(19) Europäisches Patentamt
European Patent Office
Office européen des brevets

(11) EP 2 615 888 A1

(12) EUROPEAN PATENT APPLICATION
published in accordance with Art. 153(4) EPC

(43) Date of publication:
17.07.2013 Bulletin 2013/29

(51) Int Cl.:
H05H 1/46 (2006.01)    C23C 16/505 (2006.01)
H01L 21/205 (2006.01)    H01L 21/3065 (2006.01)

(21) Application number: 10856946.8

(22) Date of filing: 06.09.2010

(86) International application number:
PCT/JP2010/065256

(87) International publication number:
WO 2012/032596 (15.03.2012 Gazette 2012/11)

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR

(71) Applicant: EMD Corporation
Shiga 520-2323 (JP)

(72) Inventors:
• EBE, Akinori
Yasu-shi, Shiga 5202323 (JP)
• WATANABE, Masanori
Katano-shi
Osaka 576-0021 (JP)

(74) Representative: Ludewigt, Christoph
Patentanwälte
Krah & Ludewigt
Am Blasiwald 24
79183 Waldkirch (DE)

(54) **PLASMA PROCESSING APPARATUS**

(57) The present invention provides an internal antenna type plasma processing device which is easily maintained and capable of producing stable plasma. The plasma processing device has a plurality of antenna units 20 provided in the top wall 111 of a vacuum chamber 11. Each of the antenna units 20 includes: a dielectric housing 21 provided to protrude into the vacuum chamber 11 from the top wall 111 of the vacuum chamber 11; a cover 22 having a second gas discharge port 25 for discharging the atmosphere in the housing to the outside of the vacuum chamber; and a radio-frequency antenna 23 formed by a conductor tube which is fixed to the cover 22 by way of a feedthrough 24 and has gas passage holes 232 in its tube walls. An inert gas is supplied into the tube of the radio-frequency antenna 23, and the inside of the housing 21 is filled with the inert gas provided through the gas passage holes 232. The inert gas is discharged to the outside of the vacuum chamber 11 through the second gas discharge port 25.

Fig. 1A

GAS INTRODUCTION

GAS DISCHARGE

(Cont. next page)

# Fig. 1B

**Description**

TECHNICAL FIELD

The present invention relates to an inductively coupled plasma processing device which can be used for various surface processings of a base body and other purposes.

BACKGROUND ART

Plasma processing devices have been used for a film formation process in which a thin-film is formed on a base body, and for an etching process on the surface of a base body. Such plasma processing devices include: a capacitively-coupled plasma processing device in which plasma is produced by the electromagnetic field generated by applying a radio-frequency voltage between electrodes; and inductively-coupled plasma processing devices in which plasma is produced by the electromagnetic field generated by feeding a radio-frequency current to a radio-frequency antenna (coil). Capacitively-coupled plasma processing devices are advantageous in that they are inexpensive compared to inductively-coupled plasma processing devices, while inductively-coupled plasma processing devices are advantageous in that they can produce high-density plasma and therefore the film formation rate is large compared to capacitively-coupled plasma processing devices.

Inductively-coupled plasma processing devices generally use an external antenna system in which a radio-frequency antenna for forming an induction electromagnetic field is provided outside a vacuum chamber. In recent years, the area of substrate bodies to be processed and thin films formed thereon have grown in size. Consequently, the size of vacuum chambers increases, which leads to the use of thicker walls in the vacuum chambers due to the difference in pressure between the outside and the inside of the vacuum chambers. This disadvantageously lowers the intensity of the induction electromagnetic field formed in a vacuum chamber, and decreases the density of the produced plasma.

On the other hand, the inductively-coupled plasma processing device described in Patent Document 1 uses an internal antenna system in which a radio-frequency antenna is provided inside a vacuum chamber. With the internal antenna system, the density of plasma can be easily increased irrespective of the thickness of the walls of a vacuum chamber. Hence, this device is suitable both large-size substrate bodies and thin films to be processed.

However, placing a radio-frequency antenna inside a vacuum chamber makes it difficult to carry out maintenance on the device. Generally, in order to prevent heating by the radio-frequency current and the consequent increase in the impedance, the radio-frequency antenna is formed using a conductor tube, and coolant is circulated in the conductor tube. This requires elaborate connection configurations between the vacuum chamber and the radio-frequency antenna, and between the ends of the conductor tube and the coolant supply/discharge ports. This makes it difficult to attach and detach the radio-frequency antenna.

Another problem is that the radio-frequency antenna is directly exposed to plasma. In an inductively-coupled plasma processing device, a direct current self-bias voltage is generated between the radio-frequency antenna and the plasma. If the device uses an external antenna system, ions accelerated by the self-bias voltage are impeded by the walls of the vacuum chamber, whereas in an internal antenna system, the antenna conductor is sputtered.

In order to prevent this, in the invention described in Patent Document 2, the surface of the radio-frequency antenna conductor is covered by a pipe made of a dielectric (or insulating) material, such as ceramics that are less sputtered than the antenna conductor, quartz, or other materials. However, forming a dielectric pipe to match the shape of the antenna requires an advanced technology and a high manufacturing cost. In addition, even if the antenna conductor tube is cooled by circulating coolant, the dielectric pipe may not be adequately cooled and may reach a very high temperature (e.g. several hundred degrees Celsius). In this case, the dielectric pipe becomes vulnerable to rupture by the thermal stress, and the antenna conductor is not sufficiently cooled due to the heat transmitted from the dielectric pipe. This increases the impedance of the antenna conductor, and prevents a stable supply of plasma.

BACKGROUND ART DOCUMENT

PATENT DOCUMENT

[Patent Document 1] JP-A 7-18433
[Patent Document 2] JP-A 2001-035697

## DISCLOSURE OF THE INVENTION

## PROBLEM TO BE SOLVED BY THE INVENTION

The problem to be solved by the present invention is to provide an internal antenna-type plasma processing device which is capable of producing stable plasma, easily maintained, and is low-cost.

## MEANS FOR SOLVING THE PROBLEM

To solve the aforementioned problem, the present invention provides a plasma processing device, including:

a) a vacuum chamber;
b) a radio-frequency antenna provided so as to protrude inwards from an inner wall of the vacuum chamber; and
c) a housing made of a dielectric material for isolating the radio-frequency antenna from an atmosphere inside the vacuum chamber, the dielectric housing having no contact with the radio-frequency antenna.

With the plasma processing device according to the present invention, the dielectric housing prevents the internal antenna system radio-frequency antenna from being sputtered. This housing need not be manufactured to match the shape of the radio-frequency antenna, as required in the case of the dielectric pipe. The housing may have an appropriate shape that is easy to manufacture, which can suppress the manufacturing cost. Another advantage is that the same shape can be used for antennas of any shape. Since the radio-frequency antenna and the housing are not in contact with each other, the heat generated by feeding a radio-frequency current to the antenna conductor will not be directly transmitted to the housing.
This can suppress the temperature rise of the housing.

The plasma processing device according to the present invention may preferably include: an antenna insertion opening that connects the inside of the dielectric housing and the outside of the vacuum chamber, the antenna insertion opening being provided in the inner wall of the vacuum chamber; and a cover for closing the antenna insertion opening. This configuration allows an attachment and detachment of the radio-frequency antenna through the antenna insertion opening, facilitating the maintenance of the device. In this case, it is more preferable that the radio-frequency antenna be attached to the cover. This allows an easy setting and removal of the radio-frequency antenna just by attaching and detaching the cover to the opening.

It is preferable that the inside of the dielectric housing is filled with an inert gas, is in a vacuum, or is filled with a solid dielectric material. This prevents unrequired electric discharges from occurring inside the dielectric housing.

The radio-frequency antenna may be formed with a conductor tube through which a cooling medium can be supplied. This can suppress heating of the antenna conductor caused by radio-frequency current, and the consequent increase in the impedance.

In the case where the coolant is an inert gas, the plasma processing device according to the present invention may include: a gas passage hole or holes provided in a tube wall in a portion of the conductor tube contained in the dielectric housing; and a gas discharge port for allowing the inert gas flowing out through the gas passage hole or holes into the dielectric housing to be discharged to the outside of the dielectric housing and the vacuum chamber. This enables the inside of the dielectric housing to be filled with an inert gas, which can prevent unrequired electric discharges from occurring inside the dielectric housing. Simultaneously, the conductor tube is cooled both from outside and inside, which prevents increase in the impedance of the antenna conductor and enables a stable supply of plasma. In addition, since the dielectric housing can also be cooled, the dielectric housing is prevented from breaking due to thermal stresses.

The radio-frequency antenna may be formed by a linear conductor formed in a shape in which a U-shaped portion or a cornered U-shaped (or rectangular) portion is included. A U-shaped conductor or a cornered U-shaped portion includes two parallel straight sections. When an electric current is fed to the conductor, the directions of the electric current flowing through the two straight sections oppose (i.e. lie at 180 degree angle). Therefore, the directions of the magnetic field lines generated from the electric current flowing through the two straight sections become the same in the area between the two straight sections, which enables obtaining a large intensity of the magnetic field and the plasma density in this area.

The plasma processing device according to the present invention may include a plurality of the radio-frequency antennas and the dielectric housings. This allows a production of substantial plasma within the whole vacuum chamber with high uniformity of plasma density.

## EFFECTS OF THE INVENTION

In the plasma processing device according to the present invention, the radio-frequency antenna is provided so as to protrude inwards from the inner wall of the vacuum chamber, and the radio-frequency antenna is surrounded by the dielectric housing which has no contact with the radio-frequency antenna. This prevents the radio-frequency antenna from being sputtered regardless of the shape of the antenna. Since this dielectric housing has a shape simpler than a dielectric pipe, it is easy to manufacture, which can lower the manufacturing cost. Maintenance of the radio-frequency antenna can be facilitated when the plasma processing device includes: the antenna insertion opening for connecting the dielectric housing and the outside of the vacuum chamber, the antenna insertion opening being provided in the inner wall of the vacuum chamber; and a cover for closing the antenna insertion opening. When the dielectric housing is filled with an inert gas and the inert gas is circulated, a production of unwanted electric discharges in the dielectric housing and a temperature rise of the antenna conductor are prevented. This enables a stable supply of plasma.

BRIEF DESCRIPTION OF THE DRAWINGS

Fig. 1A is a vertical sectional view of a plasma processing device according to the first embodiment of the present invention, and Fig. 1B is a vertical sectional view showing the configuration around a radio-frequency antenna.
Fig. 2 is a graph showing a result of a measurement of the density of plasma generated by using the plasma processing device of the first embodiment.
Fig. 3 is a vertical sectional view showing a configuration around the radio-frequency antenna in the plasma processing device of the second embodiment.
Figs. 4A and 4B are vertical sectional views showing a configuration around the radio-frequency antenna in the plasma processing device of the third embodiment.
Figs. 5A and 5B are vertical sectional views showing a configuration around the radio-frequency antenna in the plasma processing device of the fourth embodiment.
Fig. 6A is a vertical sectional view showing a configuration around the radio-frequency antenna in the plasma processing device of the fifth embodiment, Fig. 6B is a perspective view of the radio-frequency antenna, and Fig. 6C is a top view thereof.
Fig. 7 is a top view showing another shape of the radio-frequency antenna of the plasma processing device of the fifth embodiment.
Fig. 8A is a perspective view of the radio-frequency antenna of the plasma processing device of the sixth embodiment, Fig. 8B is a top view thereof, and Fig. 8C is a side view thereof.
Fig. 9 is a vertical sectional view showing a configuration around the radio-frequency antenna of the plasma processing device of the seventh embodiment.
Fig. 10 is a top view of the radio-frequency antenna of the plasma processing device of the eighth embodiment.

BEST MODES FOR CARRYING OUT THE INVENTION

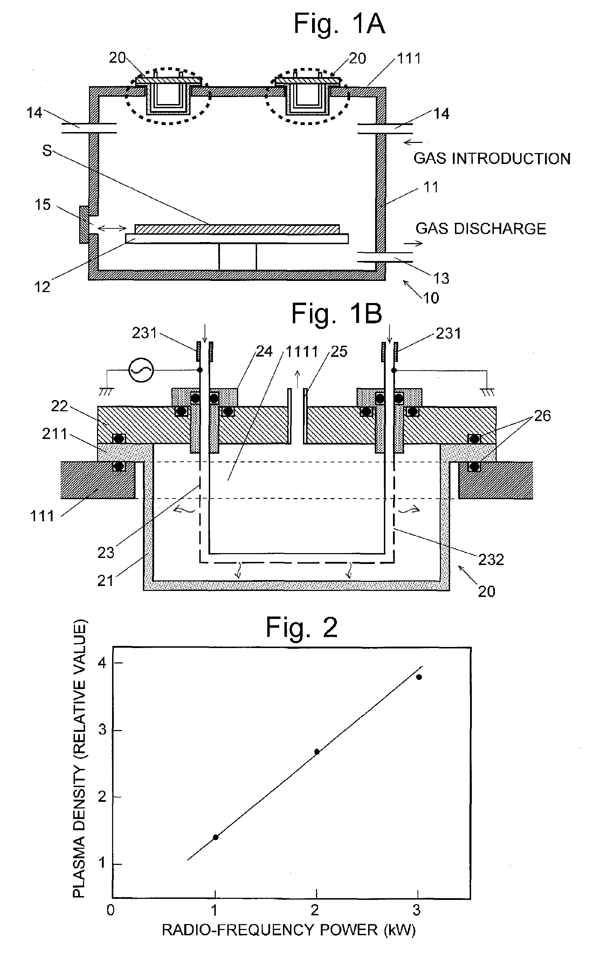

Embodiments of the plasma processing device according to the present invention are described with reference to Figs. 1 through 8.

FIRST EMBODIMENT

First, the plasma processing device 10 of the first embodiment will be described. As shown in Fig. 1A, the plasma processing device 10 includes: a vacuum chamber 11; a base-body holder 12 placed in the vacuum chamber 11; a first gas discharge port 13 and a first gas introduction ports 14 which are provided in the side wall of the vacuum chamber 11; and a plurality of antenna units 20 provided in the top wall 111 of the vacuum chamber 11. The first gas discharge port 13 is connected to a vacuum pump. By means of the vacuum pump, the air, steam and other contents in the vacuum chamber 11 are discharged from the first gas discharge port 13 to create a high vacuum state inside the vacuum chamber 11. The first gas introduction ports 14 are used for introducing a plasma production gas (e.g. hydrogen gas) and a material gas into the vacuum chamber 11. The base body S to be held on the base-body holder 12 is loaded into the vacuum chamber 11 through a base-body transfer opening 15 or unloaded from the vacuum chamber 11. The base-body transfer opening 15 is hermetically closed except when the base body S is loaded into or unloaded from the vacuum chamber 11.

The antenna unit 20 will now be described. As shown in Fig. 1B, the antenna unit 20 includes a rectangular-parallelepiped dielectric housing 21 composed of dielectric walls. The dielectric housing 21 has a flange 211 and a cover 22. The dielectric housing 21 is inserted from the outside of the vacuum chamber 11 into an opening 1111 provided in the top wall 111 of the vacuum chamber 11. When the dielectric housing 21 is attached to the top wall 111, the flange 211 hooks on the periphery of the opening 1111. A vacuum seal 26 is provided both between the flange 211 and the top wall 111 and between the flange 211 and the cover 22 so as to prevent a gas leakage through them. The dielectric material for the dielectric housing 21 may be metal oxide, nitride, carbide, fluoride, or other materials. Among these materials, it is preferable to use quartz, alumina, zirconia, yttria, silicon nitride, or silicon carbide.

A radio-frequency antenna 23 which is formed with a cornered U-shaped conductor is placed inside the dielectric housing 21. The portions of both ends of the cornered U-shaped conductor are fixed to the cover 22 via a feedthrough 24 for ensuring the air tightness and the electric insulation between the radio-frequency antenna 23 and the cover 22. One end of the cornered U-shaped conductor is connected to a radio-frequency power source and the other end is connected to a ground. The cornered U-shaped conductor is formed with a tube, to which second gas introduction ports 231 are provided at both ends for introducing an inert gas into the tube. Gas passage holes 232 for sending the inert gas in the tube into the dielectric housing 21 are provided on the outer side of the tube wall of the cornered U-shaped conductor, i.e. on the side facing the dielectric walls of the dielectric housing 21. The cover 22 has a second gas discharge port 25 for discharging the inert gas and the remaining gas (air) other than the inert gas in the dielectric housing 21 to the outside thereof. In this configuration, a gas passage is formed from the second gas introduction ports 231, the gas passage holes 232, and the dielectric housing 21 to the second gas discharge port 25.

In the present embodiment, the internal dimensions of the dielectric housing 21 are 5 cm in depth (the vertical direction of Fig. 1B), 13 cm on the long side (the horizontal direction of Fig. 1B), and 1.8 cm on the short side (the direction perpendicular to a plane including the cornered U-shaped conductor). The length of the bottom portion of the cornered U-shaped conductor of the radio-frequency antenna 23 is 10 cm. The distance between the bottom portion of the cornered U-shaped conductor and the bottom of the dielectric housing 21 is 0.6 cm. The outside diameter of the cornered U-shaped conductor is 6.4 mm.

As an example of the operation of the plasma processing device 10 of the first embodiment, the process of depositing a film-forming material on the base body S is hereinafter described. Initially, a base body S is loaded through the base-body transfer opening 15 into the vacuum chamber 11 and placed onto the base-body holder 12. After the base-body transfer opening 15 is closed, the air, steam and other contents in the vacuum chamber 11 are discharged through the first gas discharge port 13 using the vacuum pump. Meanwhile, an inert gas is introduced from the second gas introduction ports 231 into the dielectric housing 21 through the conductor tube and the gas passage holes 232. This replaces the air in the dielectric housing 21 with the inert gas and discharges the air and excess inert gas through the second gas discharge port 25 to the outside of the dielectric housing 21.

Subsequently, while the inert gas is being supplied, a plasma production gas and a material gas are introduced from the first gas introduction ports 14, and a radio-frequency power is supplied to the radio-frequency antenna 23. By means of this radio-frequency power supply, an induction electromagnetic field is produced around the radio-frequency antenna 23. This induction electromagnetic field is introduced through the walls of the dielectric housing 21 into the vacuum chamber 11 and ionizes the plasma production gas, whereby plasma is produced. The material gas, which has been introduced into the vacuum chamber 11 together with the plasma production gas, is decomposed by the resultant plasma, to be deposited on the base body S.

While the radio-frequency power is being supplied to the radio-frequency antenna 23, the inert gas is blown at the dielectric walls of the dielectric housing 21 through the conductor tube and the gas passage holes 232. Therefore, the inert gas serves as a coolant for suppressing the temperature rise of the radio-frequency antenna 23 and the dielectric walls caused by the radio-frequency power supply.

In comparison to an external type, the plasma processing device 10 of the present embodiment can create a stronger induction electromagnetic field within the vacuum chamber 11 as the radio-frequency antenna 23 is located in the dielectric housing 21 protruding into the vacuum chamber 11. Furthermore, since the radio-frequency antenna 23 is separated from the vacuum chamber 11 by the walls of the dielectric housing 21, the plasma is prevented from etching into the radio-frequency antenna 23 and shortening its life, and the material of the radio-frequency antenna 23 is prevented from being mixed, as an impurity, into the film being formed or the base body being processed.

In addition, the inert gas is introduced from the second gas introduction ports 231 through the conductor tube and the gas passage holes 232 into the dielectric housing 21, so that the dielectric housing 21 is filled with the inert gas. This can prevent unrequired electric discharge and can cool the radio-frequency antenna 23 with the inert gas which serves as a coolant. As just described, the plasma processing device 10 of the present embodiment can prevent an electric discharge, and cool the radio-frequency antenna 23 and the dielectric housing 21 by a single gas supply means, which allows a simplification of the apparatus.

A plasma production experiment was performed using the plasma processing device 10 of the present embodiment. In the experiment, a mixture gas of argon and hydrogen (plasma production gas) was introduced into the vacuum chamber 11 through the first gas introduction ports 14 to a pressure of 1 Pa. Simultaneously, a nitrogen gas (inert gas) was introduced from the second gas introduction ports 231 to the conductor tube and the dielectric housing 21 at a rate of 2.5 liters per minute. Then, a radio-frequency power of 13.56 MHz in frequency and 1 kW in output was supplied to the radio-frequency antenna 23. After a sufficient amount of time, a plasma with the plasma density of $1.2 \times 10^{11} \mathrm{cm}^{-3}$ was observed at a point located 10 cm below the bottom of the dielectric housing 21. The plasma density is almost inversely proportional to the distance from the bottom of the cornered U-shaped conductor. When the output of the radio-frequency power was varied within the range of 1 kW to 3 kW, the plasma density changed substantially in proportion to the output of the radio-frequency power (Fig. 2). It was possible to keep the temperatures of the radio-frequency antenna 23 and the dielectric housing 21 at 80 °C or less by cooling them with the inert gas.

SECOND EMBODIMENT

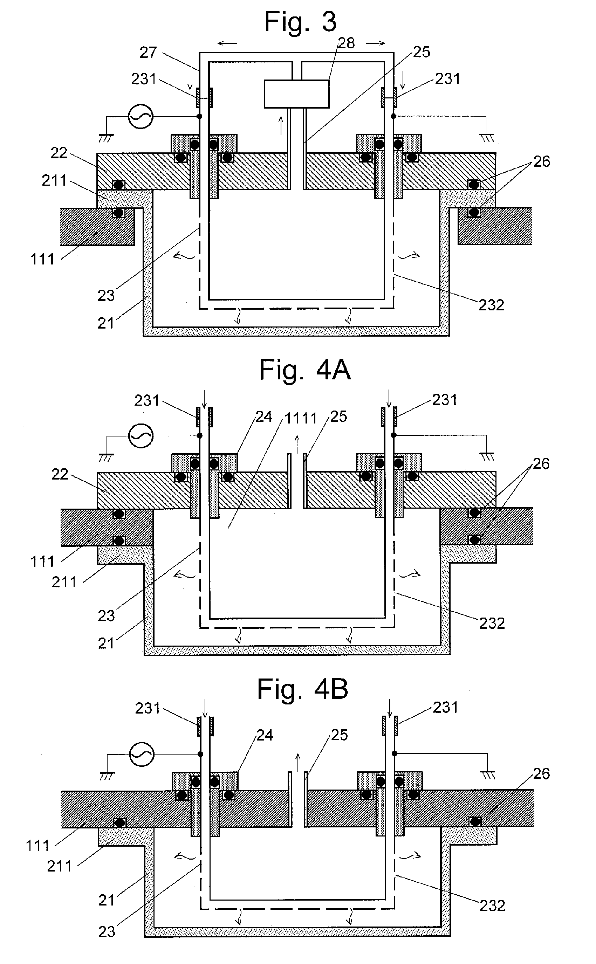

In the plasma processing device 10 of the first embodiment, as shown in Fig. 3, the second gas discharge port 25 and the second gas introduction ports 231 may be connected to each other with a connection tube 27, and a pump and a heat exchanger 28 may be provided between the second gas discharge port 25 and the second gas introduction ports 231. The second gas introduction port 231 and the connection tube 27 which are connected on the side of the radio-frequency power source are electrically insulated by inserting a dielectric member between the second gas introduction port 231 and the connection tube 27. Alternatively, the connection tube 27 may be made of a dielectric material. With this configuration, the inert gas discharged from the second gas discharge port 25 is cooled by the heat exchanger 28 and can be introduced again into the second gas introduction ports 231. That is, the inert gas can be circulated and reused. Air may be circulated as a coolant gas for economic efficiency.

THIRD EMBODIMENT

In the plasma processing device 10 of the first embodiment, the dielectric housing 21 may be attached so as to cover the opening 1111 of the vacuum chamber 11 from below, and the cover 22 may be attached so as to cover the opening 1111 from above (Fig. 4A). In this case, the flange 211 of the dielectric housing 21 is fixed to the lower surface of the top wall 111, and the cover 22 is fixed to the upper surface of the top wall 111. Alternatively, the dielectric housing 21 may be attached to the lower surface of the top wall 111 without an opening (Fig. 4B). In this case, the radio-frequency antenna 23 is fixed to the top wall 111 and a cover is not necessary.

FOURTH EMBODIMENT

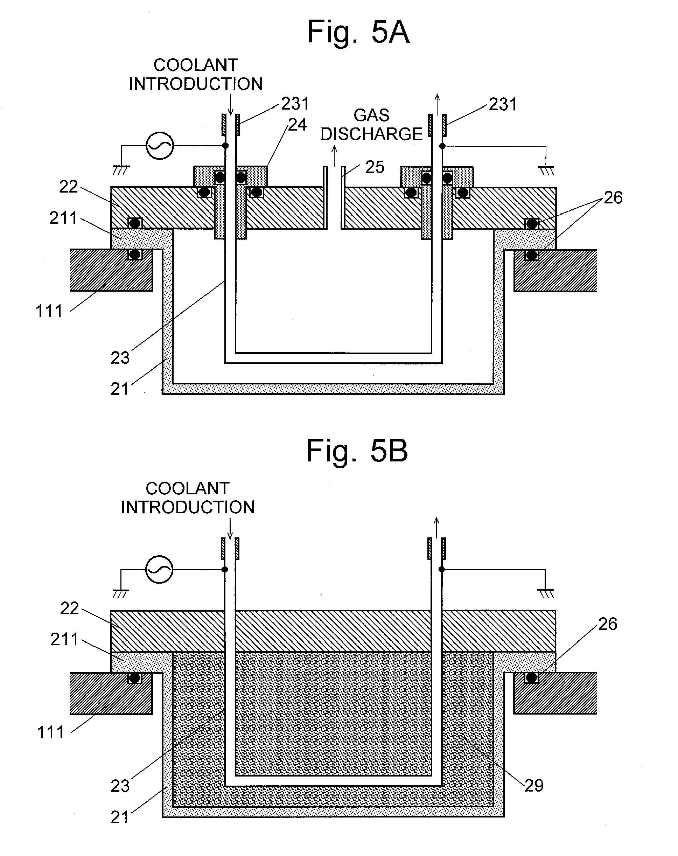

Instead of being filled with an inert gas, the inside of the dielectric housing 21 may become a vacuum by discharging gas from the second gas discharge port 25 using a vacuum pump (Fig. 5A). In this case, although the gas passage holes 232 are not provided, it is preferable to form the radio-frequency antenna 23 by means of a conductor tube and flow a coolant, such as a coolant gas and cooling water, through the tube in order to cool the radio-frequency antenna 23. With this configuration, it is possible to prevent electric discharge from occurring within the dielectric housing 21, as in the case where an inert gas is used, and thermally insulate the space between the radio-frequency antenna 23 and the walls of the dielectric housing 21. Therefore, the temperature rise of the dielectric housing 21 can be suppressed.

Alternatively the inside of the dielectric housing 21 may be filled with a solid dielectric material 29 (Fig. 5B). The dielectric material 29 may be in bulk form or in powder form. In the case where a powder is used, the dielectric housing 21 is hermetically closed so that air does not enter the spaces in the powder. Available materials for the dielectric material 29 may be polytetrafluoroethylene (PTFE), polyether ether ketone (PEEK), other kinds of resin, alumina, silica or other kinds of ceramics. The dielectric material 29 can prevent electric discharge from occurring in the dielectric housing 21. Also in this case, it is preferable to form the radio-frequency antenna 23 by a conductor tube and to flow a coolant, such as a coolant gas and cooling water, through the tube in order to cool the radio-frequency antenna 23.

FIFTH EMBODIMENT

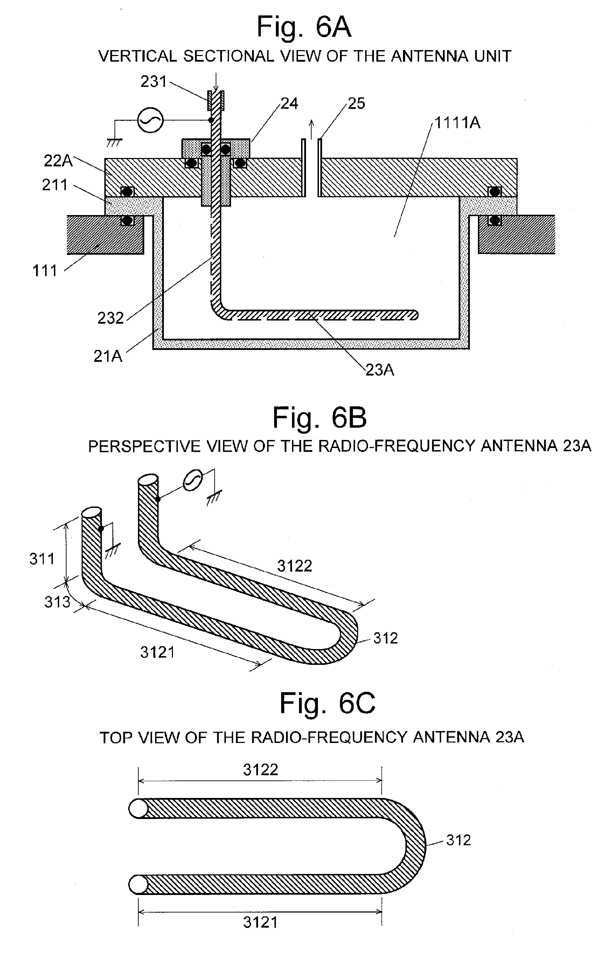

Next, an example is described in which the radio-frequency antenna 23A with a different shape is used (Figs. 6A through 6C). Other than the shape of the radio-frequency antenna 23A and the sizes of the opening 1111A, the dielectric housing 21A and the cover 22A, the plasma processing device of the present embodiment has the same configuration as the plasma processing device 10 of the first embodiment. The radio-frequency antenna 23A includes: two feet 311 extending downward from the cover 22; a U-shaped section 312 provided so that the plane formed by the U-shape is parallel to the bottom surface of the housing 21A (i.e. perpendicular to the insertion direction of the radio-frequency antenna 23A into the vacuum chamber 11); and two bend sections 313 for connecting one end of the U-shaped section 312 to a foot 311 and connecting the other end of the U-shaped section 312 to the other foot 311.

In the present embodiment, the length of the two straight sections (a first straight section 3121 and a second straight section 3122) of the U-shaped section 312 is 10 cm, and the distance between the conductors of the first straight section 3121 and the second straight section 3122 is 3 cm. The "distance between the conductors" means the distance between the inner sides of the two parallel conductors. The short side length of the inside of the dielectric housing 21A is 6 cm, which is longer than that of the dielectric housing 21 of the first embodiment, so as to correspond to the shape of the radio-frequency antenna 23A. The depth and the long side length of the inside of the dielectric housing 21A are the same as those of the dielectric housing 21 of the first embodiment. The sizes of the opening 1111A and the cover 22A are larger in the short side direction than those in the first embodiment so as to correspond to the short side of the inside of the dielectric housing 21A.

In the radio-frequency antenna 23A having a shape of Figs. 6A through 6C, the radio-frequency electric currents in the first straight section 3121 and the second straight section 3122, which are parallel to the bottom surface of the housing 21A, flow in the opposite direction. Therefore, in the space immediately below the housing 21A, the vertical component of the magnetic field formed by the electric current flowing through the first straight section 3121 and that formed by the electric current flowing through the second straight section 3122 vibrate in the same phase, which approximately doubles the intensity of the magnetic field in the space below the housing 21 in the devices of the first through the fourth embodiments. This enables a production of electric discharge plasma with a relatively low radio-frequency power, and a stable production of discharge plasma even with a gas pressure which hinders the occurrence of electric discharge, i.e. 0.5 Pa or less.

An experiment was performed using the plasma processing device of the present embodiment under the same conditions as the first embodiment. That is, a mixture gas of argon and hydrogen was introduced into the vacuum chamber 11 to a pressure of 1 Pa. Simultaneously, a nitrogen gas was introduced from the second gas introduction ports 231 into the conductor tube and the dielectric housing 21 at a rate of 2.5 liters per minute. Then, a radio-frequency power of 13.56 MHz in frequency and 1 kW in output was supplied to the radio-frequency antenna 23A. After a sufficient amount of time, a plasma with the plasma density of $1.8 \times 10^{11} cm^{-3}$ was observed at a point located 10 cm below the bottom of the dielectric housing 21. This value is greater than that ($1.2 \times 10^{11} cm^{-3}$) in the first embodiment.

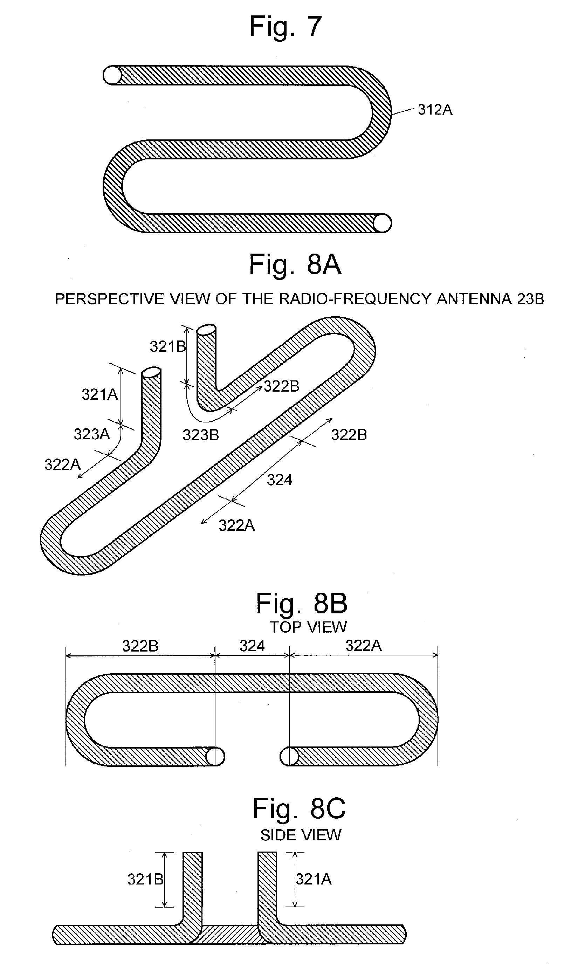

In the present embodiment, the explanation for a U-shape is given. However, the U-shaped section 312 may be replaced by a cornered U-shaped unit, as in the first through the fourth embodiments, or may be replaced by an S-shaped section 312A as shown in Fig. 7. Alternatively, N-shape or M-shape is also available.

In the radio-frequency antenna 23B of the present embodiment, if the U-shaped section 312 is replaced by a commonly-used circular antenna conductor, the intensity $H_0$ of the magnetic field generated in the center of the antenna conductor is expressed by the following formula:

$$H_0 = I/(2r),$$

where denotes the radius, and I denotes the intensity of the applied electric current.

In the case where a U-shaped antenna conductor is used, the intensity $H_{11}$ of the magnetic field in the center of the antenna conductor is expressed by the following formula:

$$H_{11} = 2I/(\pi d),$$

where $d$ denotes the distance between the two straight sections.

That is, when a U-shaped antenna conductor is used, the intensity of the magnetic field will be $4r/(\pi d)$ times as large as that of the circular antenna conductor. In this case, since the intensity of the magnetic field is inversely proportional to the value of $d$, as the distance between the two straight sections becomes narrower, the intensity of the inductive magnetic field increases. In the present embodiment, a U-shaped antenna conductor having the same length as that of the circular antenna conductor could produce a magnetic field of an approximately 1.7-fold strength. The value of the ratio $d$/L is not particularly limited, where $d$ denotes the distance between the two parallel conductors in a U-shaped or cornered U-shaped section and L denotes the length of the two conductors in their longitudinal direction. However, it is preferable that the value of the ratio is between 0.05 and 0.5. The entire length of the antenna conductor may be preferably equal to or less than a quarter of the wavelength of the radio-frequency power supplied to the radio-frequency antenna.

SIXTH EMBODIMENT

Another example of the shape of the radio-frequency antenna is now described with reference to Figs. 8A through 8C. In the present embodiment, the radio-frequency antenna 23B includes: a first foot 321A and a second foot 321B both of which extend downward from the cover 22B; a first U-shaped section 322A and a second U-shaped portion 322B both of which are provided so that the plane formed by the U-shape is parallel to the cover 22; a first bend section 323A and a second bend section 323B; and a linear connector 324. The first foot 321A and one end of the first U-shaped section 322A are connected by the first bend section 323A, and the second foot 321B and one end of the second U-shaped section 322B are connected by the second bend section 323B. The other end of the first U-shaped section 322A and the other end of the second U-shaped section 322B are connected by the linear connector 324. Using the radio-frequency antenna of the present embodiment can increase the vertical components of the magnetic field in the space below the dielectric housing, as in the fifth embodiment.

SEVENTH EMBODIMENT

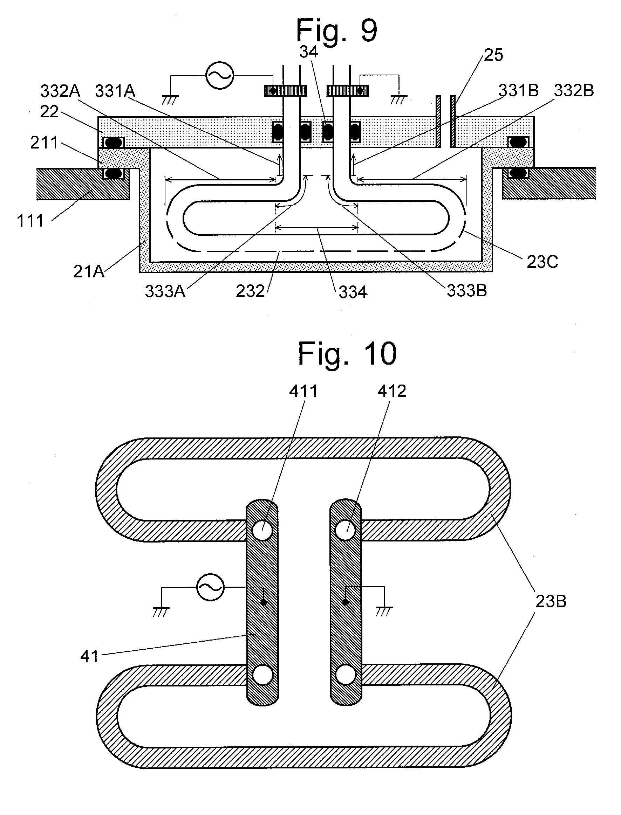

Another example of the shape of the radio-frequency antenna is now described with reference to Fig. 9. In the present embodiment, a radio-frequency antenna 23C is formed by a conductor tube and includes: a first foot 331A and a second foot 331B both of which extend downward from the cover 22; a first U-shaped section 332A and a second U-shaped section 332B both of which are provided so that a plane formed by the U-shape is parallel to the cover 22; a first bend section 333A and a second bend section 333B; and a linear connector 334. The first foot 331A and one end of the first U-shaped section 332A are connected by the first bend section 333A, and the second foot 331B and one end of the second U-shaped section 332B are connected by the second bend section 333B. The other end of the first U-shaped section 332A and the other end of the second U-shaped section 332B are connected by the linear connector 334. In the tube wall of the conductor tube, gas passage holes 232 are provided on the sides facing the dielectric walls of the dielectric housing 21 as in the first embodiment.

In the present embodiment, a feedthrough is omitted in order to decrease the distance between the first foot 331A and the second foot 331B. Instead, an insulator cover 22 is used for electrical insulation from the radio-frequency antenna 23C, and a vacuum seal 34 is provided between the first foot 331A and the cover 22 and between the second foot 331B and the cover 22.

In the present embodiment, the total length of the linear section of the first U-shaped section 332A, the linear connector 334, and the linear section of the second U-shaped section 332B in the radio-frequency antenna 23C is 10 cm, the distance between the two linear sections of the U-shaped sections is 3 cm, and the outside diameter is 6.4 mm. The dimensions of the dielectric housing 21A are the same as those of the fifth embodiment (5 cm depth, 13 cm long side, and 6 cm short side).

In the present embodiment, the plane, including the first U-shaped section 332A and the second U-shaped section 332B, is provided so as to be parallel to the insertion direction of the radio-frequency antenna 21. Therefore, a strong oscillating magnetic field is formed on both sides of this plane, which can further increase the density of the plasma produced in the vacuum chamber 11. Since the direction of the magnetic field lines generated from the radio-frequency antenna 23C is almost parallel to the inner walls of the vacuum chamber 1l, the electrons in the plasma bound by the magnetic field lines are prevented from being scattered toward the inner walls of the vacuum chamber 11. Hence, it is possible to generate stable electric discharge plasma in the vacuum chamber 11.

An experiment was performed using the plasma processing device of the present embodiment under the same conditions as those of the first and the fifth embodiments. That is, a mixture gas of argon and hydrogen was introduced into the vacuum chamber 11 to a pressure of 1 Pa. Simultaneously, a nitrogen gas was introduced from the second gas introduction ports 231 into the conductor tube and the dielectric housing 21 at a rate of 2.5 liters per minute. Then, a radio-frequency power of 13.56 MHz in frequency and 1 kW in output was supplied to the radio-frequency antenna 23A. After a sufficient amount of time, a plasma with the plasma density of $2.2 \times 10^{11} cm^{-3}$ was observed at a point located 10 cm below the bottom of the dielectric housing 21. This value is higher than that ($1.2 \times 10^{11} cm^{-3}$) in the first embodiment and that ($2.2 \times 10 cm^{-3}$) in the fifth embodiment. This is because high-density plasma was generated on both sides of the U-shaped portions of the radio-frequency antenna 23C, and the resultant plasma reached the space under the dielectric housing 21.

EIGHTH EMBODIMENT

An example of the plasma processing device including a plurality of radio-frequency antennas is now described with reference to Fig. 10. In the present embodiment, two radio-frequency antennas 23B, which are used also in the sixth embodiment, are provided. The feeding ends of the two radio-frequency antennas are connected to each other by a busbar 41, and their ground ends are connected to each other by another busbar 41. Each of the busbars 41 has a feeding point in the center area. A radio-frequency power source is connected to the feeding point of the busbar which connects the feeding ends 411. The feeding point of the busbar which connects the ground ends 412 is connected to a ground.

The distances from the feeding points to the feeding terminals of the antennas 23B are approximately the same. The positions of the feeding points are adjusted so that the impedances of the two antennas 23B to the radio-frequency current are equal with respect to the feeding points. In the present embodiment, a mixture gas of argon and hydrogen of 0.5 Pa in gas pressure was introduced into the vacuum chamber, and a radio-frequency power of 13.56 MHz in frequency and 1 kW in output was supplied to the feeding point, so that electric discharge plasma was excited in the vacuum chamber.

With this configuration, approximately uniform electric discharge plasma was generated in the vacuum chamber 11 using both radio-frequency antennas 23B. The plasma density distribution at a certain distance from the top wall 111 varies depending on the pressure of the electric discharge gas, radio-frequency power, and other factors. However, the conditions for obtaining a uniform plasma density distribution are a design choice, and electric discharge plasma of any size can be generated.

The two radio-frequency antennas may be provided in one dielectric housing, or may be provided in different dielectric housings. Providing a plurality of radio-frequency antennas can increase the size of substrate bodies to be processed, and the size of thin films formed thereon, improving the mass productivity of the device.

In the aforementioned embodiment, a pair of radio-frequency antennas are used. However, the number of radio-frequency antennas is not limited to two, but may be three or more. Alternatively, a plurality of groups of multiple radio-frequency antennas may be aligned.

EXPLANATION OF NUMERALS

| | |
|---|---|
| 10 | Plasma Processing Device |
| 11 | Vacuum Chamber |
| 111 | Top Wall |
| 1111 | Opening |
| 1111A | Opening |
| 12 | Base-Body Holder |
| 13 | First Gas Discharge Port |
| 14 | First Gas Introduction Port |
| 15 | Base-Body Transfer Opening |
| 20 | Antenna Unit |
| 21, 21A | Dielectric Housing |
| 211 | Flange |
| 22, 22A | Cover |
| 23, 23A, 23B, 23C | Radio-Frequency Antenna |
| 231 | Second Gas Introduction Port |
| 232 | Gas Passage Hole |
| 24 | Feedthrough |
| 25 | Second Gas Discharge Port |
| 26 | Vacuum Seal |
| 27 | Connection Tube |
| 28 | Heat Exchanger |
| 29 | Dielectric Member |
| 311 | Foot |
| 312 | U-Shaped Section |
| 3121 | First Straight Section |
| 3122 | Second Straight Section |
| 312A | S-Shaped Section |
| 313 | Bend Section |
| 321A | First Foot |
| 321B | Second Foot |
| 322A | First U-Shaped Section |
| 322B | Second U-Shaped Section |
| 323A | First Bend Section |
| 323B | Second Bend Section |
| 324, 334 | Linear Connector |
| 331A | First Foot |
| 331B | Second Foot |
| 332A | First U-Shaped Section |

(continued)

| | |
|---|---|
| 332B | Second U-Shaped Section |
| 333A | First Bend Section |
| 333B | Second Bend Section |
| 34 | Vacuum Seal |
| 41 | Busbar |
| 411 | Power Supply End |
| 412 | Grounded End |
| S | Base Body |

**Claims**

1. A plasma processing device, comprising:

   a) a vacuum chamber;
   b) a radio-frequency antenna provided so as to protrude inwards from an inner wall of the vacuum chamber; and
   c) a housing made of a dielectric material for isolating the radio-frequency antenna from an atmosphere inside the vacuum chamber, the dielectric housing having no contact with the radio-frequency antenna.

2. The plasma processing device according to claim 1, comprising:

   an antenna insertion opening provided in the inner wall of the vacuum chamber for connecting an inside of the dielectric housing and an outside of the vacuum chamber; and
   a cover for closing the antenna insertion opening.

3. The plasma processing device according to claim 2, wherein the radio-frequency antenna is attached to the cover.

4. The plasma processing device according to any one of claims 1 through 3, wherein the radio-frequency antenna is formed by a conductor tube through which a cooling medium can be supplied.

5. The plasma processing device according to claim 4, wherein the cooling medium is an inert gas or air.

6. The plasma processing device according to claim 5, comprising:

   a gas passage hole provided in a tube wall in a portion of the conductor tube contained in the dielectric housing; and
   a gas discharge port for allowing the inert gas or air flowing out through the gas passage hole into the dielectric housing to be discharged to an outside of the dielectric housing and the vacuum chamber.

7. The plasma processing device according to any one of claims 1 through 5, wherein an inside of the dielectric housing is filled with an inert gas.

8. The plasma processing device according to any one of claims 1 through 5, wherein an inside of the dielectric housing is a vacuum.

9. The plasma processing device according to any one of claims 1 through 5, wherein an inside of the dielectric housing is filled with a solid dielectric material.

10. The plasma processing device according to any one of claims 1 through 9, wherein a shape of the radio-frequency antenna includes a U-shape or a cornered U-shape.

11. The plasma processing device according to claim 10, wherein a plane including the U-shape or the cornered U-shape is perpendicular to or parallel to an insertion direction of the radio-frequency antenna into the vacuum chamber.

12. The plasma processing device according to either claim 10 or 11, wherein a ratio of a distance between two parallel straight sections in the U-shape or the cornered U-shape of the conductor to a length in a longitudinal direction of the straight sections is between 0.05 and 0.5.

13. The plasma processing device according to any one of claims 1 through 12, wherein a length of the conductor of the radio-frequency antenna is equal to or less than a quarter of a wavelength of a radio-frequency power supplied to the radio-frequency antenna.

14. The plasma processing device according to any one of claims 1 through 13, wherein the dielectric housing is made of a metal oxide, nitride, carbide, or fluoride.

15. The plasma processing device according to any one of claims 1 through 14, wherein the dielectric housing is made of quartz, alumina, zirconia, yttria, silicon nitride, or silicon carbide.

16. The plasma processing device according to any one of claims 1 through 15, comprising a plurality of the radio-frequency antennas and the dielectric housings.

## Fig. 1A

GAS INTRODUCTION

GAS DISCHARGE

## Fig. 1B

## Fig. 2

## Fig. 3

## Fig. 4A

## Fig. 4B

# Fig. 5A

# Fig. 5B

# Fig. 6A

## VERTICAL SECTIONAL VIEW OF THE ANTENNA UNIT

# Fig. 6B

## PERSPECTIVE VIEW OF THE RADIO-FREQUENCY ANTENNA 23A

# Fig. 6C

## TOP VIEW OF THE RADIO-FREQUENCY ANTENNA 23A

## Fig. 7

312A

## Fig. 8A

PERSPECTIVE VIEW OF THE RADIO-FREQUENCY ANTENNA 23B

321B
321A
322B
323A
323B
322B
322A
324
322A

## Fig. 8B

TOP VIEW

322B   324   322A

## Fig. 8C

SIDE VIEW

321B   321A

# Fig. 9

# Fig. 10

<table>
<tr><td colspan="2" align="center">**INTERNATIONAL SEARCH REPORT**</td><td colspan="2">International application No.<br>PCT/JP2010/065256</td></tr>
</table>

A. CLASSIFICATION OF SUBJECT MATTER
*H05H1/46*(2006.01)i, *C23C16/505*(2006.01)i, *H01L21/205*(2006.01)i,
*H01L21/3065*(2006.01)i

According to International Patent Classification (IPC) or to both national classification and IPC

B. FIELDS SEARCHED

Minimum documentation searched (classification system followed by classification symbols)
H05H1/46, C23C16/505, H01L21/205, H01L21/3065

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y | WO 2009/110226 A1 (EMD Corp.),<br>11 September 2009 (11.09.2009),<br>claims; paragraphs [0009] to [0040]; fig. 1 to 8<br>(Family: none) | 1-4,8-11,<br>14-16<br>1-16 |
| Y | JP 57-9868 A (Tokyo Shibaura Electric Co., Ltd.),<br>19 January 1982 (19.01.1982),<br>page 2, lower right column, line 17 to page 3, upper left column, line 16; drawings<br>(Family: none) | 1-16 |

☒ Further documents are listed in the continuation of Box C.       ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>29 November, 2010 (29.11.10) | Date of mailing of the international search report<br>07 December, 2010 (07.12.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/065256

C (Continuation). DOCUMENTS CONSIDERED TO BE RELEVANT

| Category* | Citation of document, with indication, where appropriate, of the relevant passages | Relevant to claim No. |
|---|---|---|
| Y | JP 61-284033 A (The Institute of Physical and Chemical Research), 15 December 1986 (15.12.1986), entire text; all drawings (Family: none) | 1-16 |
| Y | JP 63-62198 A (The Institute of Physical and Chemical Research), 18 March 1988 (18.03.1988), entire text; all drawings (Family: none) | 1-16 |
| Y | JP 2004-265919 A (Tokyo Electron Ltd.), 24 September 2004 (24.09.2004), paragraphs [0019] to [0023]; fig. 1 & US 2007/0113978 A1 & WO 2004/070813 A1 | 1-16 |
| Y | JP 2007-149638 A (Nissin Electric Co., Ltd.), 14 June 2007 (14.06.2007), paragraphs [0055] to [0056]; fig. 1 & US 2007/0144672 A1 & KR 10-2007-0045957 A | 1-16 |
| Y | JP 2009-182023 A (Ulvac, Inc.), 13 August 2009 (13.08.2009), entire text; all drawings (Family: none) | 1-16 |

Form PCT/ISA/210 (continuation of second sheet) (July 2009)

**INTERNATIONAL SEARCH REPORT**

| International application No. |
|---|
| PCT/JP2010/065256 |

---

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III      Observations where unity of invention is lacking (Continuation of item 3 of first sheet)**

This International Searching Authority found multiple inventions in this international application, as follows:

    The invention in claim 1 of this application is described in the document
1 (WO 2009/110226 A1), and therefore cannot be considered to be novel and
does not have a special technical feature.  Consequently, the inventions in
claims 1 - 16 do not involve one or more of the same or corresponding special
technical features and cannot be considered to comply with unity of invention.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**     ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**EP 2 615 888 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7018433 A
- JP 2001035697 A